# EUROPÄISCHE PATENTSCHRIFT

(11) **EP 2 234 917 B1**
(45) Veröffentlichungstag und Bekanntmachung des Hinweises auf die Patenterteilung: **08.05.2019**
(21) Anmeldenummer: 08862452.3
(22) Anmeldetag: 20.10.2008
(51) Int. Cl.: B81C 1/00

(54) **VERFAHREN ZUM HERSTELLEN EINES KAPPENWAFERS FÜR EINEN SENSOR**
METHOD FOR PRODUCING A CAPPING WAFER FOR A SENSOR
PROCÉDÉ DE FABRICATION D'UNE PLAQUETTE DE RECOUVREMENT POUR UN CAPTEUR

(30) Priorität: 17.12.2007 DE 102007060632
(43) Veröffentlichungstag der Anmeldung: 06.10.2010
(73) Patentinhaber: Robert Bosch GmbH, 70442 Stuttgart (DE)
(72) Erfinder: REICHENBACH, Frank, 72827 Wannweil (DE); LAERMER, Franz, 71263 Weil Der Stadt (DE); KRONMUELLER, Silvia, 71409 Schwaikheim (DE); SCHEURLE, Andreas, 71229 Leonberg (DE)
(86) Internationale Anmeldenummer: PCT/EP2008/064126
(87) Internationale Veröffentlichungsnummer: WO 2009/077234

(56) Entgegenhaltungen:
- EP-A- 1 749 794
- US-A- 5 424 245
- US-A1- 2004 077 154
- US-A1- 2006 211 233
- US-B2- 7 275 424

## Beschreibung

Die Erfindung betrifft ein Verfahren zum Herstellen eines Kappenwafers für einen Sensor, insbesondere einen Kraftfahrzeugsensor. Ferner betrifft die Erfindung ein Verfahren zum Herstellen eines Sensorstacks, insbesondere eines Inertialsensorstacks, mit wenigstens einem Sensor. Darüber hinaus betrifft die Erfindung einen Kappenwafer, einen Sensor mit einer erfindungsgemäßen Kappe, und eine Anordnung eines Substrats mit einem erfindungsgemäßen Sensor.

Ein Sensor, besonders ein mikroelektromechanischer Sensor (MEMS-Sensor), insbesondere ein kapazitiver Inertialsensor zur Messung von Beschleunigungen und/oder Drehraten, wird in der Regel gemeinsam mit einem IC-Chip, welcher ein Sensorrohsignal auswertet und vorverarbeitet, in ein Kunststoffgehäuse verpackt. Vor dem Einbau des Sensors in das Kunststoffgehäuse, wird eine empfindliche Sensorstruktur mit einer Kappe versehen. Diese ist notwendig, um bewegliche Sensorstrukturen vor Folgeprozessen, unter anderem einer Vergelung, zu schützen, und um einen gewünschten Innendruck und somit eine Schwingungsgüte des Sensors einstellen zu können.

Hierfür wird noch vor einem Vereinzeln einer Vielzahl von (kapazitiven Inertial-)Sensoren, ein so genannter Kappenwafer mittels Sealglasverbindungen auf einen elektrischen Sensorwafer gebondet. Es entsteht ein so genannter Sensorstack, der den Sensor- und den daran festgelegten Kappenwafer umfasst, wodurch eine Vielzahl von einander fest verbundenen Sensoren ausgebildet werden. Hierbei wird das Sealglas in Rahmenform um Kavernen des Kappenwafers herum, durch ein Siebdruckverfahren aufgebracht. Durch das Sealglas (Glaslot) wird ein hermetischer Verschluss zwischen Kappenwafer und Sensorwafer im Bereich der Kavernen gewährleistet.

Die Kavernen haben die Aufgabe, eine relative Änderung eines eingeschlossenen Volumens zwischen Kappen- und Sensorwafer bei einer Quetschung des Sealglases klein zu halten und als Druck- oder Vakuumreservoir für den später vereinzelten Sensor zu dienen. Die Zugänge zu den elektrischen Anschlüssen (Bondpads) des jeweiligen Sensors liegen außerhalb dieses Rahmens und sind im Kappenwafer bereits in einer geeigneten Weise ausgespart und dadurch zugänglich gemacht. S. hierzu z. B. die DE 197 00 734 A1.

Nach dem Vereinzeln des Sensorstacks können die einzelnen Sensoren in das Kunststoffgehäuse geklebt werden. Die elektrischen Verbindungen vom Sensor zum IC-Chip und die elektrischen Verbindungen von den elektrischen Anschlüssen des Gehäuses zu den Bondpads des IC-Chips werden mittels Bonddrähten realisiert. Anschließend werden die Bonddrähte vergelt und das Kunststoffgehäuse verschlossen. Erst jetzt ist das dadurch entstehende Sensorelement bereit, um auf eine Leiterplatte gelötet zu werden. Ein solches Vorgehen ist bei Sensoren mit Hybridaufbau (Zweichiplösung mit Sensor- und IC-Chip) zwingend, da die störanfälligen, hochohmigen elektrischen Verbindungen zwischen (kapazitiven) Sensor und einer Auswerteelektronik definiert ausgeführt, mechanisch fixiert und geschützt werden müssen.

Die US 7 275 424 B2 offenbart ein Herstellungsverfahren eines Sensorstacks sowie einen Sensorstack, bzw. ein Herstellungsverfahren eines verkappten Sensors sowie einen Sensor. Hierbei werden in einen Kappenwafer Kavernen und außerhalb einer Kaverne elektrisch isolierte Durchgangslöcher vorgesehen. Anschließend wird der Kappenwafer über eine Sealglasverbindung mit einem Sensorwafer zu einem Sensorstack weiterverarbeitet, wobei das Sealglas mittels eines Siebdruckverfahrens auf den Kappenwafer aufgebracht wird und anschließend die Sealglasverbindung zwischen dem Kappenwafer und dem Sensorwafer ausgebildet wird. Danach werden die Durchgangslöcher des Sensorstacks mit einem dotierten Polysilikonmaterial oder durch eine chemische Vernickelung derart aufgefüllt, dass sich eine elektrische Kontaktierung zu innerhalb des Sensorstacks liegenden Aluminiumkontakten des Sensorwafers ergibt. Darauf folgend wird ein zwischen den Kappen- und dem Sensorwafer befindlicher Zwischenraum mit einem Polymer gefüllt, eine Außenseite am Kappenwafer des Sensorstacks, mit einer elektrischen Isolationsschicht versehen und anschließend eine elektrische Außenkontaktierung des Sensorstacks an der äußeren Isolationsschicht vorgesehen. Hierfür wird die Isolationsschicht im Bereich der internen elektrischen Kontaktierung zu den inneren Aluminiumkontakten, frei geätzt und mit einem Metall aufgefüllt, welches sich unter Ausbildung einer Lasche bis auf die Außenseite der Isolationsschicht erstreckt. Auf die jeweilige Lasche wird ein Lotbump gesetzt, um die Sensoren auf eine Leiterplatte verlöten zu können.

Problematisch hierbei ist, dass erst nach einem Verbinden des Sensor- mit dem Kappenwafer eine elektrische Durchkontaktierung des Sensorstacks eingerichtet wird. Gelingt ein Füllprozess der Durchgangslöcher nicht, muss der gesamte Sensorstack oder wenigstens ein Teil davon verschrottet werden. Ferner kann bei diesem Verfahren kein einzelner Kappenwafer mit einer Durchkontaktierung hergestellt werden, wodurch sich ein solches Verfahren auch nicht an einen Zulieferer auslagern lässt. Darüber hinaus ist es nicht möglich, die Durchgangslöcher durch ein galvanisches Verfahren zu füllen, wodurch man bei einer Wahl eines Materials für die Durchkontaktierung sowie für ein Füllverfahren für letztere eingeschränkt ist.

Ein Verfahren, bei dem eine Vertiefung in einem Bauelement galvanisch gefüllt wird, ist in US 5 424 245 angegeben.

Aus dem Dokument US 2004/0077154 ist ein Verfahren zum Herstellen eines Wafers bekannt, bei dem getrennte Ätzschritte zum Herstellen von Durchgangslöchern und auch eine Kaverne zur Aufnahme einer MEMS-Vorrichtung verwendet werden.

Es ist daher eine Aufgabe der Erfindung, ein verbessertes Verfahren zum Herstellen eines Kappenwafers und/oder eines Sensorstacks anzugeben. Ferner ist es eine Aufgabe der Erfindung, einen verbesserten Kappenwafer, einen verbesserten Sensor und eine Anordnung eines erfindungsgemäßen Sensors auf einem Substrat anzugeben. Hierbei soll es erfindungsgemäß möglich sein, einen Sensor ohne ein zusätzliches Gehäuse und dennoch resistent gegenüber Umwelteinflüssen, direkt auf einem Substrat vorzusehen. Hierbei soll ein Kappenwafer eines Sensorstacks vollständig separat herstellbar sein. Ferner soll eine elektrische Durchkontaktierung des Kappenwafers durch ein galvanisches Verfahren herstellbar sein. Darüber hinaus soll erfindungsgemäß ein Ausschuss bei der Herstellung eines Sensors verringert sein.

Die Aufgabe der Erfindung wird durch ein Verfahren zum Herstellen eines Kappenwafers, insbesondere eines Sealglaskappenwafers, gemäß Anspruch 1, und ein Verfahren zum Herstellen eines Sensorstacks, insbesondere eines Inertialsensorstacks, gemäß Anspruch 5 gelöst.

Ein erfindungsgemäßer separater Kappenwafer weist dabei metallische Durchkontaktierungen von einer Vorder- zur Rückseite auf, wobei diese elektrischen Durchkontaktierungen die Positionen der elektrischen Sensoranschlüsse auf ein Niveau heben, mit welchem es möglich ist, durch ein Flippen eines vereinzelten Sensors eine direkte Lötverbindung mit einem Substrat, z. B. einer Leiterplatte, herzustellen. Hierbei weist ein elektrischer Kontaktstift der Durchkontaktierung einen direkten elektrischen Anschluss für einen separaten Sensorwafer auf. Darüber hinaus ist es bevorzugt, dass der elektrische Kontaktstift ferner einen elektrischen Anschluss für das Substrat besitzt.

In bevorzugten Ausführungsformen der Erfindung schließt der betreffende elektrische Anschluss der Durchkontaktierung im Wesentlichen bündig mit der Vorder- und/oder Rückseite des Kappenwafers ab, oder weist an der Vorder- und/oder Rückseite einen Vorsprung auf und steht von der betreffenden Seite ab. Hierbei kann ein jeweiliger elektrischer Anschluss ein im Wesentlichen plan mit der betreffenden Seite liegender Seitenkontakt, ein Anschlagkontakt oder ein Lotbump sein. In bevorzugten Ausführungsformen der Erfindung ist die erfindungsgemäße elektrische Durchkontaktierung des Kappenwafers durch einen Galvanikverfahren hergestellt. Hierbei ist es möglich, einen elektrischen Anschluss ebenfalls mittels des Galvanikverfahrens auszubilden, was bevorzugt für denjenigen elektrischen Anschluss gilt, welcher später einen betreffenden elektrischen Anschluss des Sensorwafers elektrisch kontaktiert. Hierdurch erhält man einen elektrischen Kontakt in Form eines Press- oder Andruckkontakts.

Einen erfindungsgemäßen Sensorstack erhält man bevorzugt dadurch, dass der erfindungsgemäße Kappenwafer mittels einer Sealglasverbindung mit dem Sensorwafer mechanisch fest und stoffschlüssig verbunden wird. Hierbei wird bevorzugt auf die Vorderseite des Kappenwafers Sealglas an den betreffenden Bereichen, bevorzugt mittels eines Siebdruckverfahrens, aufgebracht, und anschließend durch ein Verpressen unter Hitze mit dem Sensorwafer, der Sensorstack hergestellt. Hierbei kontaktieren die elektrischen Durchkontaktierungen des Kappenwafers die betreffenden elektrischen Anschlüsse des Sensorwafers, die bevorzugt als Bondpads am Sensorwafer ausgebildet sind, wobei es bevorzugt ist, dass die betreffenden elektrischen Kontakte des Kappenwafers als mittels der Galvanik hergestellte Anschlagkontakte ausgebildet sind. Erfindungsgemäß können vor oder nach dem Vereinzeln des Sensorstacks, der Sensorstack oder die vereinzelten Sensoren mit Lotbumps an den betreffenden elektrischen Kontakten auf der Rückseite des Kappenwafers versehen werden.

Die erfindungsgemäße Anordnung umfasst ein Substrat, insbesondere eine Leiterplatte, und einen aus dem Sensorstack vereinzelten Sensor, wobei der Sensor direkt auf der Leiterplatte mechanisch fest und diese elektrisch kontaktierend vorgesehen ist. Hierbei kontaktiert ein elektrischer Kontakt des Sensors, insbesondere ein elektrischer Kontakt einer Kappe des Sensors, das Substrat elektrisch. Hierdurch ist es möglich, Sensorsignale aus einer Sensoreinrichtung des Sensors, durch die Kappe des Sensors hindurch, zum Substrat zu transportieren.

Die für die Erfindung in bevorzugten Ausführungsformen notwendige Galvanik ist bevorzugt eine Gold-Galvanik. Es ist jedoch erfindungsgemäß möglich, eine andere Galvanik oder ein anderes Verfahren anzuwenden. Darüber hinaus ist es möglich, für die elektrische Durchkontaktierung ein beliebiges elektrisch leitendes Material zu verwenden.

Das erfindungsgemäße Verfahren zum Herstellen des Kappenwafers ist gekennzeichnet durch die Schritte, Herstellen von Kontaktierungs-Durchgangslöchern (nachfolgend als Kontaktierungslöcher bezeichnet) zwischen der Vorder- und der Rückseite des Kappenwafers, und einem anschließenden Füllen der Kontaktierungslöcher mit einem elektrisch leitenden Material. Hierbei kann, wie oben ausgeführt, das elektrisch leitende Material ein beliebiges elektrisch leitendes Material sein. Bevorzugt werden die Kontaktierungslöcher mittels einer Galvanik, bevorzugt einer Gold-Galvanik, gefüllt. Ferner ist es hierbei bevorzugt, das das galvanische Verfahren derart lange andauert, dass wenigstens an einer Seite des Kappenwafers, an den Bereichen der Kontaktierungslöcher, das elektrisch leitende Material hervortritt und ein elektrischer Anschlagkontakt entsteht, der von der betreffenden Seite des Kappenwafers absteht.

Zeitlich vor dem Herstellen der Kontaktierungslöcher wird, rückseitig an einem Siliziumwafer (Kappenwafer) eine elektrische Isolationsschicht, insbesondere Siliziumoxid, auf- bzw. eingebracht. Anschließend wird auf diese elektrische Isolationsschicht Kupfer, gegebenenfalls mit einer Haftschicht, aufgebracht. Parallel zum rückseitigen Auf-/Einbringen der elektrischen Isolationsschicht, kann vorderseitig ebenfalls eine elektrische Isolationsschicht, insbesondere Siliziumoxid, auf- bzw. eingebracht werden.

Anschließend wird der Erfindung auf der Vorderseite des Kappenwafers eine Trenchmaske für die Kontaktierungslöcher und für die Kavernen des Kappenwafers ausgebildet. D. h. die Trenchmaske weist für die Kontaktierungslöcher und die Kavernen entsprechende Öffnungen auf. Anschließend werden die Kavernen-Öffnungen in der Trenchmaske mittels einer Lackmaske abgedeckt. Danach findet ein Trenchverfahren statt, durch welches die Kontaktierungslöcher und die Kavernen innerhalb des Kappenwafers ausgebildet werden. Hierbei ist es bevorzugt, dass die Kavernen nicht so weit in den Kappenwafer hineingearbeitet werden, wie die Kontaktierungslöcher.

Erfindungsgemäß werden zunächst die Kontaktierungslöcher angetrencht, d. h. es entstehen Sacklöcher innerhalb des Kappenwafers bis zu einer bestimmten Tiefe. Anschließend wird die Lackmaske entfernt und der Trenchprozess weitergeführt. Hierbei entstehen die sich vollständig durch den Kappenwafer hindurch erstreckenden Kontaktierungslöcher und die Kavernen. Hierbei ist es bevorzugt, dass das Trenchverfahren nach dem vollständigen Ausbilden der Kontaktierungslöcher stoppt; d. h. die Kavernen sind genauso tief, wie die Kontaktierungslöcher im zweiten Schritt des Trenchverfahrens in den Kappenwafer hineingearbeitet werden. D. h. auch, dass im ersten Schritt des Trenchverfahrens, dieses derart lange durchgeführt wird, bis eine verbleibende Dicke des Kappenwafers zwischen dessen elektrischer Isolationsschicht und den Trenchböden der entstehenden Kontaktierungslöcher, genauso groß ist, wie eine spätere Tiefe der Kavernen innerhalb des Kappenwafers. Es ist jedoch auch möglich, nach dem vollständigen Ausbilden der Kontaktierungslöcher, die Kavernen bis zu einer bestimmten Tiefe weiter zu ätzen.

Für eine spätere einwandfreie Funktion der Kappen sind die Kontaktierungslöcher des Kappenwafers an ihrer jeweiligen Innenwand elektrisch isoliert. Hierfür kann z. B. eine Seitenwandpassivierung innen in den Kontaktierungslöchern abgeschieden werden, wobei sich diese Passivierung auch innerhalb der Kontaktierungslöcher an der Rückseite des Kappenwafers ausbildet. D. h. die Passivierung bildet sich auch an der elektrischen Isolationsschicht des Kappenwafers innerhalb der Kontaktierungslöcher aus.

Um das Galvanikverfahren an der Kupferschicht als Plating-Base innerhalb der Kontaktierungslöcher starten zu können, muss die am Boden der Kontaktierungslöcher abgeschiedene Passivierung sowie die rückseitige elektrische Isolationsschicht des Kappenwafers im Bereich der Kontaktierungslöcher entfernt werden. D. h. die Passivierung einschließlich des Rückseitenoxids am Trenchboden werden bevorzugt anisotrop geöffnet. Hierbei entstehen innen elektrisch isolierte, vollständig durch den Kappenwafer hindurch gehende Kontaktierungslöcher, die stirnseitig (Rückseite) nur noch durch die rückseitige Kupferschicht des Kappenwafers geschlossen sind.

Nun werden mittels des galvanischen Verfahrens die Kontaktierungslöcher gefüllt. Hierbei füllen sich die Kontaktierungslöcher beginnend, innen an der Kupferschicht an der Rückseite des Kappenwafers und wachsen in Richtung Vorderseite. Hierbei kann das galvanische Verfahren derart lange fortgeführt werden, bis das abgeschiedene Material aus den Kontaktierungslöchern hervortritt und dort einen elektrischen Kontakt, bevorzugt einen elektrischen Anschlagkontakt bildet. Hierbei bildet sich bevorzugt ein teilsphärischer Anschlagkontakt aus, sodass die jeweilige elektrische Durchkontaktierung in einer Seitenansicht pilzförmig aufgebaut ist. Für das galvanische Verfahren eignen sich sämtliche für ein galvanisches Verfahren geeignete, elektrisch leitende Materialien, wobei Edel- und Halbedelmetalle aufgrund ihrer sehr guten elektrischen Leitfähigkeit bevorzugt sind.

Nach der Galvanik wird die Plating-Base bzw. die Kupferschicht entfernt und es entsteht ein Kappenwafer, der mit einem Sensorwafer zu einem Sensorstack vereinigt werden kann. Hierfür werden der Kappenwafer und der Sensorwafer in einer geeigneten Art und Weise miteinander verbunden. In bevorzugten Ausführungsformen der Erfindung erfolgt dies über eine Sealglasverbindung zwischen Kappen- und Sensorwafer. Hierfür wird bevorzugt auf den Kappenwafer das Sealglas mittels einer Siebdruckmaske aufgebracht. Es ist jedoch auch möglich, das Sealglas auf den Sensorwafer aufzubringen. Hierbei bilden sich Sealglasrahmen bzw. -lippen auf dem Kappen- bzw. dem Sensorwafer aus.

Danach wird der Kappenwafer an den Sensorwafer gebondet, wodurch ein erfindungsgemäßer Sensorstack entsteht. Nun kann der Sensorstack zu Sensoren vereinzelt werden, und der jeweilige Sensor auf seiner Rückseite im Bereich der durch die gefüllten Kontaktierungslöcher entstehenden elektrischen Kontakte, mit Lotbumps versehen werden. Es ist erfindungsgemäß auch möglich, vor dem Vereinzeln des Sensorstacks, die Lotbumps im Bereich der jeweiligen elektrischen Rückseitenkontakte am Sensorstack vorzusehen und erst anschließend den Sensorstack zu Sensoren zu vereinzeln.

In bevorzugten Ausführungsformen der Erfindung erfolgt ein elektrisches Kontaktieren von Sensor- und Kappenwafer unmittelbar durch, bevorzugt als Bondpads, ausgebildete elektrische Anschlagkontakte des Kappenwafers, und den elektrischen Anschlüssen des Sensorwafers, die aus den gefüllten Kontaktierungslöchern hervorstehen. Hierbei sitzen die elektrischen Anschlagkontakte direkt auf den elektrischen Anschlüssen des Sensorwafers und kontaktieren diese elektrisch.

Nach dem Vorsehen der Lotbumps am Sensor bzw. den Vereinzeln des mit Lotbumps versehenen Sensorstacks zu Sensoren, kann der erfindungsgemäß verkappte Sensor auf das Substrat, z. B. die Leiterplatte oder eine Keramik, geflippt und direkt auf das Substrat gelötet werden.

Erfindungsgemäß ist es möglich, einen Sensor, insbesondere einen mikroelektromechanischen Sensor, ohne ein zusätzliches (Kunststoff-)Gehäuse und dennoch widerstandsfähig gegen Umwelteinflüsse, als einen "Nacktchip" auf ein Substrat, insbesondere eine Leiterplatte zu löten. Das durch die Erfindung mögliche, vollständig separate Herstellungsverfahren eines erfindungsgemäßen Kappenwafers hat herstellungstechnische Vorteile. Insbesondere wird durch die separate Prozessierung des Kappenwafers ein höherer Ertrag erreicht. Gelingt ein Füllprozess der Kontaktierungslöcher nicht, so muss erfindungsgemäß nur die Kappe bzw. der Kappenwafer und nicht der gesamte Sensor bzw. ein gesamter Sensorstack verschrottet werden. Darüber hinaus ist es durch die Erfindung möglich, eine elektrische Durchkontaktierung für den Sensor bzw. den Kappenwafer durch ein galvanisches Verfahren vorzusehen.

Zusätzlich besteht erfindungsgemäß die Möglichkeit, den Füllprozess der Kontaktierungslöcher oder den gesamten Herstellungsprozess des Kappenwafers in einer separaten Linie oder Foundry durchführen zu lassen. Viele Hersteller von mikroelektromechanischen Sensoren und/oder Halbleiterfabriken besitzen keine Galvanik und möchten diese aus Kontaminationsgründen auch nicht anschaffen. Wird das Galvanikverfahren ausschließlich am Kappenwafer durchgeführt, so kann man die Herstellung des Kappenwafers bedenkenlos auslagern, denn der betreffende Zulieferer bekommt dadurch nur Informationen über den Kappenwafer und erfährt darüber hinaus keine weiteren Firmengeheimnisse bezüglich des Sensors und dessen Herstellung.

Weitere Ausführungsformen der Erfindung ergeben sich aus den übrigen abhängigen Ansprüchen.

Die Erfindung wird im Folgenden anhand von Ausführungsbeispielen unter Bezugnahme auf die beigefügte Zeichnung näher erläutert. In der Zeichnung zeigen die Fig. 1 bis 8 ein erfindungsgemäßes Herstellungsverfahren für einen erfindungsgemäßen Kappenwafer, die Fig. 8 bis 10 ein erfindungsgemäßes Herstellungsverfahren für einen erfindungsgemäßen Sensorstack bzw. einen erfindungsgemäßen Sensor, und die Fig. 11 den auf einem Substrat vorgesehenen erfindungsgemäßen Sensor.

Wenn im Folgenden von einem Kappen- bzw. einem Sensorwafer die Rede ist, so ist damit das jeweilige Einzelteil, also ein Kappen- bzw. ein Sensorwafer an sich gemeint. Befinden sich die beiden Wafer in einem aneinander festgelegten Zustand, so wird dies als Sensorstack und nicht mehr als ein Wafer bezeichnet. Ferner wird in einem Kappenwafer wenigstens eine einzelne Kappe ausgebildet bzw. der Kappenwafer weist wenigstens eine einzelne Kappe auf. Analog dazu wird im Sensorwafer wenigstens ein Sensorelement ausgebildet bzw. der Sensorwafer weist wenigstens ein einzelnes Sensorelement auf.

Gemäß der Erfindung kann ein Sensor ohne ein zusätzliches Gehäuse und dennoch unempfindlich gegen äußere Einflüsse als ein "Nacktchip" auf ein Substrat gelötet werden. Bevorzugt ist hierfür ein monolithisch integrierter Sensor, wobei dieser niedrigohmige elektrische Verbindungen zur Außenwelt aufweist. In einem solchen Fall sind die hochohmigen elektrischen Verbindungen bereits durch eine Integration des Sensors an sich soweit geschirmt, dass hierauf beim Aufbau und Verbindungskonzept keine Aufmerksamkeit mehr gelenkt werden muss. Die elektrischen Ein- und Ausgänge eines monolithisch integrierten Sensors sind elektrisch stabil, störungsunanfällig und belastbar. Eine direkte Verbindung mittels des Substrats zu anderen elektrischen oder elektronischen Komponenten ist dadurch problemlos möglich. Durch den erfindungsgemäßen Verzicht auf das Gehäuse können nicht nur Kosten eingespart werden, auch die Abmessungen des Sensors und eine Dicke des Sensorchips bzw. eine Dicke des Substrats werden erfindungsgemäß um ein beachtliches Maß reduziert. Ein solcher monolithisch integrierter Sensor umfasst neben einer Kapselung, eine Sensoreinrichtung und einen integrierten Schaltkreis, der z. B. als eine anwendungsspezifische integrierte Schaltung (ASIC - Application Specific Integrated Circuit) ausgebildet ist.

Möglich wird ein solches Vorgehen durch die Verwendung einer erfindungsgemäßen Kappenkonstruktion, die bevorzugt ebenfalls wie im Stand der Technik, mittels eines Sealglases auf ein Sensorelement gebondet ist. Mit einem derzeit bestehenden Kappenkonzept ist kein Flippen möglich, da Bondpads vertieft liegen und erst durch Aussparungen hindurch erreichbar sind, und/oder kein separates Füllen von Kontaktierungslöchern möglich ist.

Anhand der Fig. 1 bis 7 bzw. den Fig. 1 bis 8 wird nachfolgend ein erfindungsgemäßes Herstellungsverfahren eines erfindungsgemäßen Kappenwafers 100 näher erläutert, in welchem wenigstens eine Kappe 10 ausgebildet wird, was in der jeweiligen Figur in einer Querschnittsansicht dargestellt ist. Bevorzugt weist ein solcher Kappenwafer 100 jedoch eine Vielzahl von Kappen 10 auf.

Der Kappenwafer 100 wird vor einem Bondprozess, mit elektrischen Durchkontaktierungen von einer Vorderseite 101 zu einer Rückseite 102 versehen, wobei eine vollständige Prozessierung, also eine Herstellung des Kappenwafers 100, vor dem eigentlichen Bondprozess komplett abgeschlossen ist. Notwendig für eine einwandfreie Funktion der aus dem Kappenwafer 100 entstehenden Kappe 10 ist, dass die Durchkontaktierungen untereinander und zu einem Substrat des Kappenwafers 100 elektrisch isoliert sind. Dies wird beim erfindungsgemäßen Verfahren sichergestellt, indem die Innenwände 112 von Kontaktierungs-Durchgangslöchern 110 sowie die Vorder- 101 und die Rückseite 102 des Kappenwafers 100 mit einer, bevorzugt aus Siliziumdioxid 52 bestehenden, elektrischen Isolationsschicht 103, 106, 111 beschichtet werden. Eine eigentliche elektrische Durchkontaktierung des Kappenwafers 100 stellt dann ein, z. B. durch eine Galvanik abgeschiedenes, elektrisches leitendes Material 51, wie ein Metall 51, bevorzugt Gold 51, dar.

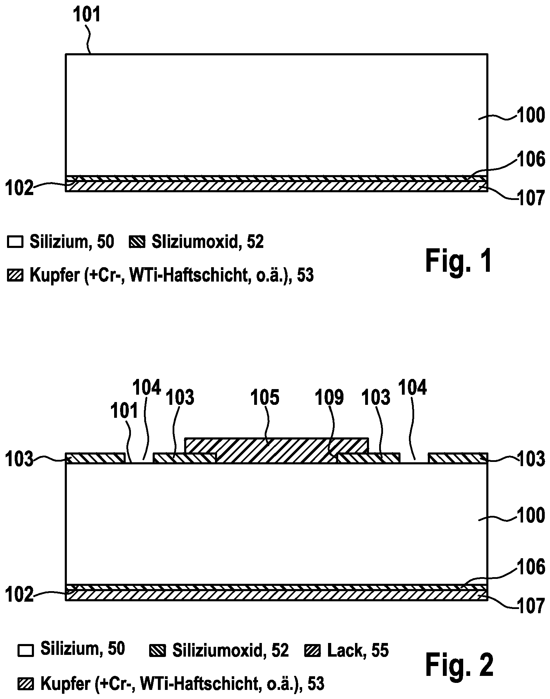

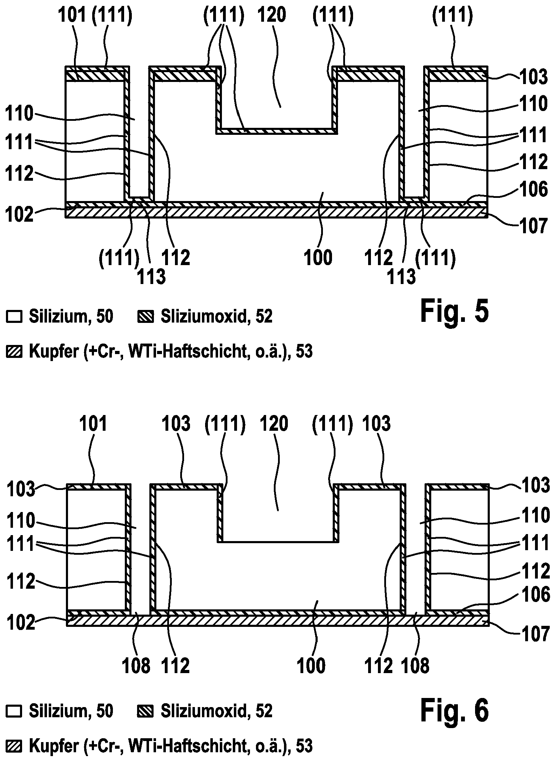

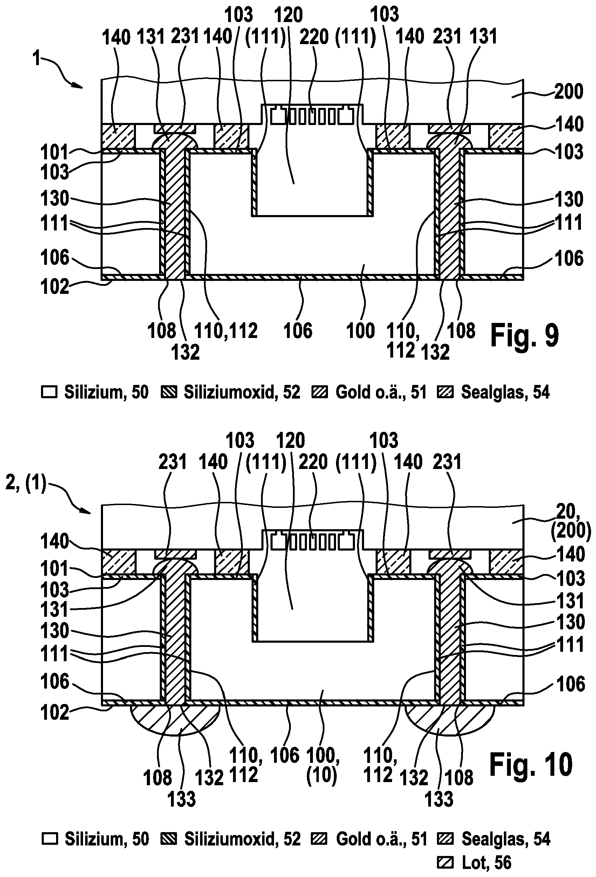

Ein erfindungsgemäßes Herstellungsverfahren für den Kappenwafer 100 kann folgendermaßen aussehen. Begonnen wird - mit Bezug auf die Fig. 1 - auf der Rückseite 102 des Kappenwafers 100 mit einem Abscheiden oder einem thermischen Aufwachsen der elektrischen Isolationsschicht 106, die bevorzugt aus Siliziumoxid 52 besteht. Im Falle eines thermischen Aufwachsens von Oxid, kann der Kappenwafer 100 vorteilhaft sogar gleichzeitig auf der Vorder- 101 und der Rückseite 102 mit der Oxidschicht 52 versehen werden; s. hierzu auch Fig. 2. Dadurch kann das spätere Abscheiden der elektrischen Isolationsschicht 103 auf der Vorderseite 101 des Kappenwafers 100 eingespart werden (s. unten). Wie auch die folgende elektrische Isolationsschicht 111 (s. Fig. 5), die bevorzugt ebenfalls aus Siliziumoxid 52 besteht, sollen diese Isolationsschichten 103, 106 die elektrischen Isolierungen der elektrischen Kontakte 131, 132, 133 bzw. der elektrischen Kontaktstifte 130 des Kappenwafers 100 sicherstellen (s. a. Fig. 9 und 10).

Anschließend wird auf der Rückseite 102 als Startschicht für ein Galvanikverfahren großflächig ein Metall 53, insbesondere Kupfer 53, aufgesputtert oder in einer anderen Art und Weise aufgebracht, was ebenfalls in der Fig. 1 dargestellt ist. Für den Fall eines Aufsputterns von Kupfer 53 ist es bevorzugt, dass dieses mit einer Haftschicht, z. B. aus Cr, WTi etc., auf dem Siliziumoxid 52 haftet.

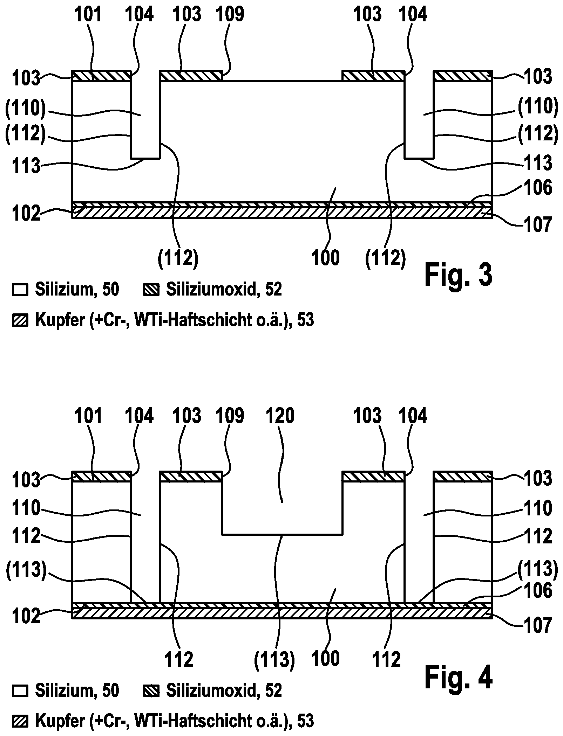

Auf der Vorderseite 101 des Kappenwafers 100 wird eine Maske für einen Tief-Trenchprozess benötigt (s. Fig. 2), die es ermöglicht, bevorzugt ohne eine erneute Lithographie, zwei unterschiedlich tiefe Trenchprozesse durchzuführen, welcher in den Fig. 3 und 4 dargestellt ist. Ein solcher Trenchprozess ist z. B. ein Tiefenstrukturierungsverfahren, wie z. B. eine Trenchätzung. Der erste Trenchprozess wird benötigt, um Kavernen 120 zu erstellen, der Zweite um die Kontaktierungs-Durchgangslöcher 110 durch den Kappenwafer 100 hindurch zu ätzen. Im Folgenden werden die Kontaktierungs-Durchgangslöcher 110 nur noch als Kontaktierungslöcher 110 bezeichnet. Die Kavernen 120 werden für die Sensoreinrichtungen 220 (s. Fig. 9 bis 11) der später entstehenden Sensoren 2 benötigt, um einen Innendruck innerhalb des betreffenden Sensors 2 besser einstellen zu können. Bei bestimmten Sensoren 2 kann auf die Kavernen 120 verzichtet werden.

Für Sensoren 2 mit Kavernen 120 wird eine Hart- 103 oder Trenchmaske 103 erstellt, was in der Fig. 2 dargestellt ist. Dies erfolgt z. B. durch Abscheiden eines Oxids 52 auf der Vorderseite 101 des Kappenwafers 100 oder durch Nutzung einer thermischen Oxidation der Rückseite 102 des Kappenwafers 100, wobei diese thermische Oxidation gleichzeitig auch auf der Vorderseite 101 das für die Maske 103 benötigte Oxid 52 erzeugt (s. o.). Nachfolgend erfolgt eine lithographische und ätztechnische Strukturierung der Maske 103, wodurch die Maske 103 beide Sorten von Ätzöffnungen 104, 109 erhält. Hierbei sind die als Durchgangsausnehmungen 104 in der Maske 103 vorgesehenen Ätzöffnungen 104 für das Trenchen der Kontaktierungslöcher 110 und die Durchgangsausnehmungen 109 als Ätzöffnungen 109 für das Trenchen der Kavernen 120 vorgesehen.

Eine Sorte von Durchgangsausnehmungen 109, welche für das Trenchen der Kavernen 120 vorgesehen sind, wird mit einer Lackmaske 105, einem so genannten Photoresist 105, abgedeckt, was z. B. durch Aufbringen eines Photolacks 55 und einer nachfolgenden (Photo-)Lithographie erfolgen kann. Die andere Sorte von Durchgangsausnehmungen 104, welche für das Trenchen der Kontaktierungslöcher 110 vorgesehen sind, ist nach dem erwähnten Lithographieschritt wieder frei von Photolack 55 und Oxid 52.

Nach dem ersten Trenchprozess werden nur die Kontaktierungslöcher 110 angeätzt, da die Durchgangsausnehmungen 104 weder mit Photolack 55 noch mit Oxid 52 bedeckt sind. Anschließend wird der auf den Durchgangsausnehmungen 109 befindliche Photolack 55 entfernt (s. Fig. 3) und anschließend der Trenchprozess weitergeführt, was in Fig. 4 dargestellt ist. Hierbei werden die Kavernen 120 und eine Fortsetzung der Kontaktierungslöcher 110 geätzt. Ein Unterschied in den Ätztiefen der Kavernen 120 und der Kontaktierungslöcher 110 lässt sich durch einen Zeitpunkt des Entfernens des Photolacks 55 steuern. Der Trench für die elektrische Durchkontaktierung des Kappenwafers 100 wird auf dem rückseitigen Oxid gestoppt. Hier ist ein Überätzen ohne Schaden möglich, wobei dann die Kavernen 120 weiter bis auf eine gewünschte Zieltiefe geätzt werden können. Insofern ist es auch möglich, zuerst die Kontaktierungslöcher 110 komplett fertig zu stellen, danach den Photolack 55 zu entfernen und dann erst die Kavernen 120 in den Kappenwafer 100 einzubringen.

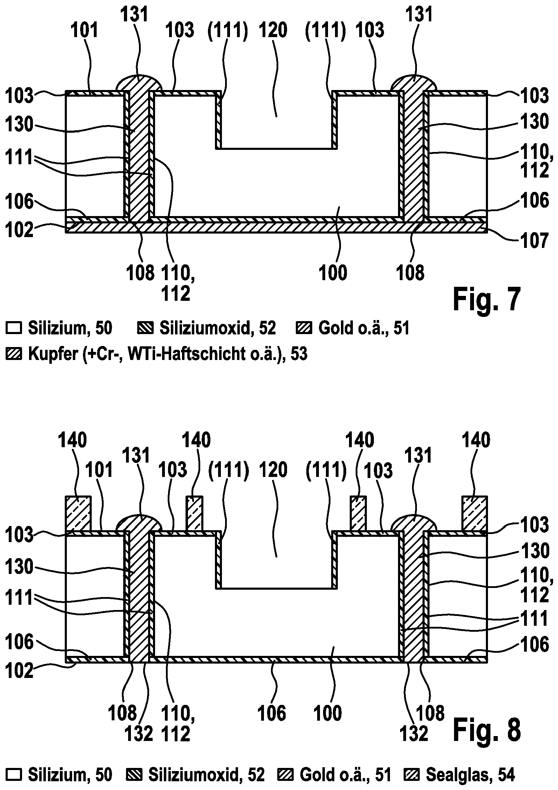

Sind die Kontaktierungslöcher 110 und die Kavernen 120 im Kappenwafer 100 vorgesehen, wird bevorzugt ein konformer Oxidabscheideprozess benötigt, welcher die Innenwände 112 der Kontaktierungslöcher 110 beschichtet. Hierfür ist beispielsweise eine TEOS-Ozonabscheidung gut geeignet. Hierbei entsteht die in Fig. 5 dargestellte elektrische Isolationsschicht 111, welche auch als Seitenwandpassivierung der Kontaktierungslöcher 110 bezeichnet wird. Vor der in Fig. 7 dargestellten, anschließenden Galvanik, muss noch, bevorzugt mit einem anisotropen Ätzprozess, das Oxid 52, bevorzugt das Siliziumdioxid 52, an den Trenchböden 113 der Kontaktierungslöcher 110 hin zum Metall 53 bzw. hin zur Haftschicht (CR, WTi etc.) des Kupfers 53 entfernt werden, welche dann ebenfalls selektiv bis zum Metall 53 abgetragen werden kann. Letzteres kann durch Nassätzlösungen erfolgen, die selektiv Cr bzw. WTi gegenüber Kupfer 53 ätzen.

Das Galvanikverfahren wird nun mit dem Kupfer 53 als Plating-Base in den Kontaktierungslöchern 110 gestartet, wodurch die Kontaktierungslöcher 110, beginnend an der Kupferschicht 107 zur Vorderseite 101 des Kappenwafers 100 hin, mit einem elektrisch leitenden Material 51, bevorzugt Gold 51, aufgefüllt werden. Wird das Galvanikverfahren derart gesteuert, dass nach der Füllung der Kontaktierungslöcher 110, Gold 51 auf der Vorderseite 101 und zu den Seiten überwächst, erhält man, bevorzugt halbkugelförmig ausgestaltete, Anschläge 131, die bei einem folgenden Bondprozess auf Bondpads 231 eines Sensorwafers 200 (s. Fig. 9 bis 11) gesetzt werden, um so elektrische Kontakte herzustellen, die z. B. in Form von elektrischen Press- oder Andruckkontakten ausgebildet sind. Für gute elektrische Kontakte und um spätere Korrosion zu verhindern, sollten die Bondpads 231 des Sensors 2 bzw. des ASICs ebenfalls mit Gold 51 beschichtet sein oder aus Gold 51 bestehen, wodurch Gold 51 auf Gold 51 Kontakte entstehen. Das Ende des Galvanikverfahrens ist in Fig. 7 dargestellt.

Vor einem Aufbringen von Sealglas 54 auf den derart präparierten Kappenwafer 100 und der Durchführung eines Bondprozesses zwischen Kappen- 100 und Sensorwafer 200, muss rückseitig am Kappenwafer 100 noch selektiv zu Gold 51 und elektrischer Isolationsschicht 106, die elektrisch leitende Schicht 107 entfernt werden (s. Fig. 8). Das Sealglas 54 wird in Form Sealglaslippen 140 bzw. -rahmen 140 auf den Kappenwafer 100 aufgebracht. Es ist erfindungsgemäß auch möglich, die Sealglaslippen 140 bzw. -rahmen 140 auf den Sensorwafer 200 aufzubringen. Im dargestellten Ausführungsbeispiel der Erfindung werden die jeweiligen Kavernen 120 mit den betreffenden Sensoreinrichtungen 220 separat auch gegenüber den betreffenden elektrischen Durchkontaktierungen gekapselt, wobei für jeden entstehenden Sensor 2 zwei umlaufende Sealglasrahmen 140 vorgesehen sind. Es ist gemäß der Erfindung jedoch auch möglich, nur einen einzigen dieser beiden Sealglasrahmen 140 vorzusehen. Es ist erfindungsgemäß nicht notwendig, die Sensoreinrichtung 220 fluiddicht zu verschließen. So ist es möglich, den Sealglasrahmen 140 offen auszugestalten und lediglich an geeigneten Stellen entsprechende Sealglaslippen 140 vorzusehen.

Das Sealglas 54 wird bevorzugt in einem Siebdruckverfahren auf den Kappenwafer 100 aufgebracht. Alternativ zu einem Siebdruckverfahren können Sealglasstreifen 140 auch mit einem Schablonendruck oder einem anderen Beschichtungsprozess vorgesehen werden. Darüber hinaus können statt Sealglas 52 auch andere Materialien eingesetzt werden, die zwei Wafer 100, 200, bevorzugt gasdicht, miteinander verbinden können, was z. B. durch Kleber, Thermoplaste oder sonstige Kunststoffe oder Lote erfolgen kann.

Anschließend wird der Kappenwafer 100 auf den Sensorwafer 200 gebondet, und man erhält einen erfindungsgemäßen Sensorstack 1, welcher in Fig. 9 dargestellt ist. Hierbei kontaktieren die elektrischen Anschlagkontakte 131 der Kontaktstifte 130 der Durchkontaktierung des Kappenwafers 100, die elektrischen Anschlüsse 231 des Sensorwafers 200.

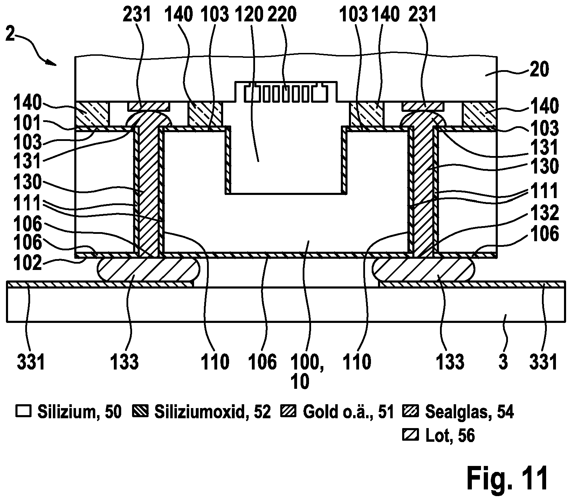

Nach dem Bondprozess ist der Sensorstack 1 bereit zum Vereinzeln, wobei die einzelnen Sensoren 2, um lötfähig zu sein, mit Lotbumps 133 versehen werden müssen. Dies kann auch noch vor dem Vereinzeln des Sensorstacks 1 erfolgen. Die Lotbumps 133 werden direkt auf die an der Rückseite 102 des Sensors 2 bzw. des Sensorstacks 1 liegenden elektrischen Kontakte 132 der Kontaktstifte 130 gesetzt. D. h. die Lotbumps 133 werden in bevorzugten Ausführungsformen der Erfindung direkt auf das Gold 51 der elektrischen Kontaktstifte 130 gesetzt und können z. B. aus einem bleifreien AgSnCu-Lot 56 bestehen. Andere Lotmaterialien 56 sind natürlich anwendbar. Alternativ können die Lotbumps 133 auch auf ein Substrat 3, insbesondere eine Leiterplatte 3 oder eine Keramik 3 gesetzt werden, auf welches ein einzelner Sensor 2 aufgelötet werden soll. Der mit dem Substrat 3 verlötete Sensor 2 ist in Fig. 11 dargestellt.

Sollte die elektrische Durchkontaktierung in einem Durchmesser zu klein und/oder eine Benetzung mit den Lotbumps 133 schwierig werden, so kann direkt zu Beginn des erfindungsgemäßen Verfahrens, auf der Rückseite 102 des Kappenwafers 100 unter das Kupfer 52 - also zwischen der elektrisch leitenden Schicht 107 und der elektrischen Isolationsschicht 106 - eine strukturierte, elektrisch leitende Schicht, insbesondere eine Goldschicht 51 aufgebracht werden, welche Benetzungsflächen für das Lot 56 vorgibt. Hierdurch ergibt sich eine vergrößerte Kontaktfläche der Lotbumps 133 mit den elektrischen Kontaktstiften 130. Zusätzlich kann dieser Schritt genutzt werden, um die Position der elektrischen Kontakte 133, also der Lotbumps 133, zu verlegen, quasi "umzuverdrahten", oder um Sägelinien und/oder Justagemarken für den Sensorstack 1 zu definieren.

Die Erfindung ist auf sämtliche Sensoren 2, insbesondere Kraftfahrzeugsensoren 2, anwendbar. Insbesondere ist die Erfindung auf alle monolithisch integrierten Sensoren 2 anwendbar, die darüber hinaus auch eine bevorzugt hermetisch dichte Kappe 10 benötigen. Dies sind insbesondere (oberflächen-)mikroelektromechanische Sensoren 2, Inertialsensoren 2 zur Messung von Beschleunigungen und/oder Drehraten, wie z. B. Drehraten- 2 oder Beschleunigungssensoren 2, und auch Resonatoren 2.

## Patentansprüche

1. Verfahren zum Herstellen eines Kappenwafers (100), insbesondere eines Sealglaskappenwafers (100), für einen Sensor (2), insbesondere einen Kraftfahrzeugsensor (2), mit wenigstens einer Kappe (10), mit den Schritten:
Herstellen eines Kontaktierungs-Durchgangslochs (110) durch den Kappenwafer (100) hindurch, und zeitlich daran anschließend, Füllen des Kontaktierungs-Durchgangslochs (110) mit einem elektrisch leitenden Material (51), wobei, zeitlich vor dem Herstellen des Kontaktierungs-Durchgangslochs (110),
auf einer Vorder- (101) und einer Rückseite (102) des Kappenwafers (100) eine elektrische Isolationsschicht (103, 106), insbesondere eine Oxidschicht (103, 106), aufgebracht wird, und zeitlich an das Aufbringen der elektrischen Isolationsschicht anschließend,
auf der Rückseite (102) des Kappenwafers (100) eine elektrisch leitende Schicht (107), insbesondere eine Kupferschicht (107), aufgebracht wird, wobei die Isolationsschicht (103) auf der Vorderseite (101) zu einer Trenchmaske (103) ausgebildet wird, wobei die Trenchmaske (103) ein erstes Durchgangsloch (104) und ein zweites Durchgangsloch (109) aufweist, wobei das erste Durchgangsloch (104) für ein Trenchen des Kontaktierungs-Durchgangslochs (110) und das zweite Durchgangsloch (109) für ein Trenchen einer Kaverne (120) vorgesehen ist, wobei das zweite Durchgangsloch (109) zunächst mit einer Lackmaske (105) abgedeckt wird, dann ein erster Trenchprozess zur Anätzung des Kontaktierungs-Durchgangslochs (110) durchgeführt wird, anschließend die Lackmaske (105) entfernt wird und daran anschließend ein zweiter Trenchprozess zum Erzeugen der Kaverne (120) und dem vollständigen Erzeugen des Kontaktierungs-Durchgangslochs (110) durchgeführt wird.

2. Verfahren gemäß Anspruch 1, wobei, zeitlich vor dem Füllen des Kontaktierungs-Durchgangslochs (110),
eine Innenwand (112) des Kontaktierungs-Durchgangslochs (110) mit einer elektrischen Isolationsschicht (111), insbesondere einer Oxidschicht (111), versehen wird, und zeitlich daran anschließend,
die elektrische Isolationsschicht (106) der Rückseite (102) des Kappenwafers (100) in einem Bereich des Kontaktierungs-Durchgangslochs (110) zur elektrisch leitenden Schicht (107) der Rückseite (102) des Kappenwafers (100) geöffnet (108) wird.

3. Verfahren gemäß einem der Ansprüche 1 oder 2, wobei das Füllen des Kontaktierungs-Durchgangslochs (110) durch ein galvanisches Verfahren erfolgt, und
das galvanische Verfahren bevorzugt derart lange andauert, bis an der Vorderseite (101) des Kappenwafers (100) ein elektrischer Anschlagkontakt (131) entsteht, wobei
das elektrisch leitende Material (51) für das galvanische Verfahren bevorzugt Gold (51) oder eine Goldlegierung (51) aufweist.

4. Verfahren gemäß einem der Ansprüche 1 bis 3, wobei, zeitlich nach dem Füllen des Kontaktierungs-Durchgangslochs (110), eine Sealglaslippe (140) auf die Vorderseite (101) des Kappenwafers (100) aufgebracht wird.

5. Verfahren zum Herstellen eines Sensorstacks (1), insbesondre eines Inertialsensorstacks (1), mit wenigstens einem Sensor (2), für den Kraftfahrzeugbereich, mit dem Schritt:
Verbinden, insbesondere Bonden, eines Kappenwafers (100) mit einem Sensorwafer (200), wobei der Kappenwafer (100) durch ein Verfahren nach einem der Ansprüche 1 bis 4 hergestellt ist.

6. Verfahren gemäß Anspruch 5, wobei ein elektrisches Kontaktieren des Sensorwafers (200) durch den Kappenwafer (100),
direkt über einen elektrischen Anschlagkontakt (131) eines elektrischen Kontaktstifts (130) des Kappenwafers (100), und einem elektrischen Anschluss (231), insbesondere einem Bondpad (231), des Sensorwafers (200) erfolgt, wobei
sich der elektrische Kontakt zwischen dem elektrischen Anschlagkontakt (131) des Kappenwafers (100) und dem elektrischen Anschluss (231) des Sensorwafers (200) bevorzugt durch einen elektrischen Press- bzw. Andruckkontakt ausbildet.

## Claims

1. Method for producing a cap wafer (100), in particular a seal glass cap wafer (100), for a sensor (2), in particular a motor vehicle sensor (2), comprising at least one cap (10), comprising the following steps: producing a contacting through hole (110) through the cap wafer (100), and, temporally after that, filling the contacting through hole (110) with an electrically conductive material (51), wherein, temporally before producing the contacting through hole (110), an electrical insulation layer (103, 106) in particular an oxide layer (103, 106), is applied on a front side (101) and a rear side (102) of the cap wafer (100), and, temporally after applying the electrical insulation layer, an electrically conductive layer (107), in particular a copper layer (107) is applied on the rear side (102) of the cap wafer (100), wherein the insulation layer (103) on the front side (101) is formed into a trench mask (103), wherein the trench mask (103) has a first through hole (104) and a second through hole (109), wherein the first through hole (104) is provided for a process of trenching the contacting through hole (110) and the second through hole (109) is provided for a process of trenching a cavity (120), wherein firstly the second through hole (101) is covered with a resist mask (105), then a first trench process for incipiently etching the contacting through hole (110) is carried out, subsequently the resist mask (105) is removed and after that a second trench process for producing the cavity (120) and for completely producing the contacting through hole (110) is carried out.

2. Method according to Claim 1, wherein, temporally before filling the contacting through hole (110), an inner wall (112) of the contacting through hole (110) is provided with an electrical insulation layer (111), in particular an oxide layer (111), and temporally after that
the electrical insulation layer (106) of the rear side (102) of the cap wafer (100) in a region of the contacting through hole (110) is opened (108) to the electrically conductive layer (107) of the rear side (102) of the cap wafer (100).

3. Method according to either of Claims 1 and 2, wherein filling the contacting through hole (110) is carried out by means of an electrolytic method, and the electrolytic method preferably has a duration lasting until an electrical stop contact (131) arises at the front side (101) of the cap wafer (100), wherein
the electrically conductive material (51) for the electrolytic method preferably comprises gold (51) or a gold alloy (51).

4. Method according to any of Claims 1 to 3, wherein, temporally after filling the contacting through hole (110), a seal glass lip (140) is applied on the front side (101) of the cap wafer (100).

5. Method for producing a sensor stack (1), in particular an inertial sensor stack (1), comprising at least one sensor (2), for the motor vehicle sector, comprising the following step:
connecting, in particular bonding, a cap wafer (100) to a sensor wafer (200), wherein the cap wafer (100) is produced by a method according to any of Claims 1 to 4.

6. Method according to Claim 5, wherein the sensor wafer (200) is electrically contacted by the cap wafer (100)
directly by way of an electrical stop contact (131) of an electrical contact pin (130) of the cap wafer (100) and an electrical connection (231), in particular a bond pad (231), of the sensor wafer (200), wherein
the electrical contact between the electrical stop contact (131) of the cap wafer (100) and the electrical connection (231) of the sensor wafer (200) is preferably formed by means of an electrical press or press-on contact.

## Revendications

1. Procédé de fabrication d'une plaquette de recouvrement (100), notamment d'une plaquette de recouvrement (100) en verre de scellement, pour un capteur (2), notamment pour un capteur de véhicule automobile (2), comportant au moins un élément de recouvrement (10) et comprenant les étapes consistant à :
réaliser un trou traversant d'interconnexion (110) à travers la plaquette de recouvrement (100), puis à remplir ledit trou traversant d'interconnexion (110) d'un matériau électriquement conducteur (51), dans lequel, avant la réalisation du trou traversant d'interconnexion (110), une couche d'isolation électrique (103, 106), notamment une couche d'oxyde (103, 106), est appliquée sur une face avant (101) et une face arrière (102) de la plaquette de recouvrement (100) et, après l'application de la couche d'isolation électrique, une couche électriquement conductrice (107), notamment une couche de cuivre (107), est appliquée sur la face arrière (102) de la plaquette de recouvrement (100), dans lequel la couche d'isolation (103) est réalisée sur la face avant (101) sous la forme d'un masque de tranchée (103), dans lequel le masque de tranchée (103) présente un premier trou traversant (104) et un deuxième trou traversant (109), dans lequel le premier trou traversant (104) est prévu pour former une tranchée destinée au trou traversant d'interconnexion (110) et le deuxième trou traversant (109) est prévu pour former une tranchée destinée à une cavité (120), dans lequel le deuxième trou traversant (109) est tout d'abord recouvert d'un masque de réserve (105), puis un premier processus de tranchée destiné à graver le trou traversant d'interconnexion (110) est réalisé, et le masque de réserve (105) est ensuite enlevé puis un deuxième processus de tranchée destiné à produire la cavité (120) et à produire entièrement le trou traversant d'interconnexion (110) est effectué.

2. Procédé selon la revendication 1, dans lequel, avant de remplir le trou traversant d'interconnexion (110),
une paroi interne (112) du trou traversant d'interconnexion (110) est dotée d'une couche d'isolation électrique (111), notamment d'une couche d'oxyde (111), puis
la couche d'isolation électrique (106) de la face arrière (102) de la plaquette de recouvrement (100) est ouverte (108) dans une zone du trou traversant d'interconnexion (110) vers la couche électriquement conductrice (107) de la face arrière (102) de la plaquette de recouvrement (100).

3. Procédé selon l'une des revendications 1 ou 2, dans lequel le remplissage du trou traversant d'interconnexion (110) est effectué par un procédé galvanique et
le procédé galvanique se poursuit de préférence jusqu'à ce qu'un contact de butée électrique (131) soit produit sur la face avant (101) de la plaquette de recouvrement (100), dans lequel
le matériau électriquement conducteur (51) destiné au procédé galvanique comprend de préférence de l'or (51) ou un alliage d'or (51).

4. Procédé selon l'une des revendications 1 à 3, dans lequel, après que le trou traversant d'interconnexion (110) a été rempli, un rebord d'étanchéité en verre (140) est appliqué sur la face avant (101) de la plaquette de recouvrement (100).

5. Procédé de fabrication d'un empilement de capteurs (1), notamment d'un empilement de capteurs inertiels (1), comportant au moins un capteur (2) destiné au domaine de l'automobile, comprenant l'étape consistant à :
relier, notamment par soudage, une plaquette de recouvrement (100) à une plaquette de capteurs (200), dans lequel la plaquette de recouvrement (100) est réalisée par un procédé selon l'une des revendications 1 à 4.

6. Procédé selon la revendication 5, dans lequel un contact électrique avec la plaquette de capteurs (200) est directement effectué par l'intermédiaire de la plaquette de recouvrement (100),
par l'intermédiaire d'un contact de butée électrique (131) d'une broche de contact électrique (130) de la plaquette de recouvrement (100) et d'une borne électrique (231), notamment d'un plot de soudage (231), de la plaquette de capteurs (200),
dans lequel le contact électrique entre le contact de butée électrique (131) de la plaquette de recouvrement (100) et la borne électrique (231) de la plaquette de capteurs (200) est de préférence réalisé par un contact de pression ou d'enfichage.
